# EUROPEAN PATENT APPLICATION

(11) **EP 4 513 517 A1**
(43) Date of publication of application: **26.02.2025**
(21) Application number: 24194136.8
(22) Date of filing: 12.08.2024
(51) Int. Cl.: H01F 21/12, H03H 7/00

(54) **SWITCHABLE COIL AND TRANSMIT CIRCUIT INCLUDING THE SAME**

(30) Priority: 22.08.2023 KR 20230110069; 06.02.2024 KR 20240018378
(71) Applicant: SAMSUNG ELECTRONICS CO., LTD., Yeongtong-gu Suwon-si, Gyeonggi-do 16677 (KR)
(72) Inventor: LEE, Wooseok, 16677 Suwon-si (KR); YOO, Sangmin, 16677 Suwon-si (KR); BAE, Jeongyeol, 16677 Suwon-si (KR); LEE, Jongsoo, 16677 Suwon-si (KR); KIM, Soyeon, 16677 Suwon-si (KR)
(74) Representative: Marks & Clerk LLP

(57) **Abstract**

A switchable coil includes a first coil (110) including a first outer coil (OC1) and a first inner coil (IC1), the first inner coil and the first outer coil forming a first crossing-region, a second coil (120) including a second outer coil (OC2) and a second inner coil (IC2), the second inner coil and the second outer coil forming a second crossing-region, and the second crossing-region being inside the first inner coil viewed in a first direction, and a switch (SW) connected to a region facing the second crossing-region in the second inner coil.

## Description

### TECHNICAL FIELD

The present invention generally relates to a switchable coil and to a transmit circuit including the same.

### BACKGROUND

Wireless communication technology utilizes expanded bandwidths to transmit a larger amount of data and improve data rates. For example, various standards related to wireless communication technology, such as Wi-Fi, which is a standard for the Institute of Electrical and Electronics Engineers (IEEE) 802. 11 series, and cellular communication of the 3^{rd} Generation Partnership Project (3GPP), have been established and developed to expand bandwidth.

For Wi-Fi, standards of Wi-Fi 6 or higher may recommend that two transmitters are considered to be implemented to expand the frequency range to a sixth generation (6G) band (ranging from about 5.925 GHz to about 7.125 GHz), in addition to a fifth generation (5G) band (ranging from about 5.180 GHz to about 5.825 GHz) and to cover the bands, but chip size is increased to accommodate the two transmitters.

### SUMMARY

The present invention is defined by the claims. Embodiments according to the present disclosure provide a switchable coil and a transmit circuit including the same.

According to embodiments, a switchable coil includes a first coil including a first outer coil and a first inner coil, the first inner coil and the first outer coil forming a first crossing-region, a second coil including a second outer coil and a second inner coil, the second inner coil and the second outer coil forming a second crossing-region, and the second crossing-region being inside the first inner coil viewed in a first direction, and a switch connected to a region facing the second crossing-region in the second inner coil.

According to embodiments, a switchable coil includes a first coil including a first outer coil and a first inner coil, the first outer coil including a first crossing end portion and a second crossing end portion, the first inner coil including a third crossing end portion and a fourth crossing end portion, and the third crossing end portion being connected to the first crossing end portion through a crossing segment, a second coil including a second outer coil and a second inner coil, the second outer coil and the second inner coil forming a crossing-region, and the crossing-region being provided inside the first inner coil viewed in a first direction, a first switch connected to a first region facing the crossing-region in the second inner coil, and a second switch connected to the second crossing end portion and the fourth crossing end portion.

According to embodiments, a transmit circuit includes a mixer configured to perform up-conversion of a transmit signal based on a local oscillator (LO) signal, and a matching network connected to an output of the mixer, the matching network including at least one switchable coil, and the switchable coil including a first coil including a first outer coil and a first inner coil, the first outer coil and the first inner coil forming a first crossing-region, a second coil including a second outer coil and a second inner coil, the second outer coil and the second inner coil forming a second crossing-region, and the second crossing-region being inside the first inner coil viewed in a first direction, and a switch connected to a first region facing the second crossing-region in the second inner coil.

### BRIEF DESCRIPTION OF THE FIGURES

The above and other objects and features according to the present disclosure will become apparent by describing in detail embodiments thereof with reference to the accompanying drawings.
FIG. 1 illustrates a switchable coil according to embodiments.
FIG. 2 illustrates a magnetic flux canceling region of the switchable coil of FIG. 1.
FIGS. 3 and 4 illustrate switching operations of the switchable coil of FIG. 1.
FIGS. 5 and 6 illustrate ideal frequency characteristics of a switchable coil according to embodiments.
FIGS. 7 and 8 illustrate frequency characteristics based on a simulation result of a switchable coil according to embodiments.
FIG. 9 illustrates a metal structure of a switchable coil according to embodiments.
FIG. 10 illustrates a metal stack structure of the switchable coil of FIG. 9.
FIG. 11 illustrates a switchable coil according to embodiments.
FIG. 12 illustrates ideal frequency characteristics of the switchable coil of FIG. 11.
FIG. 13 illustrates a switchable coil according to embodiments.
FIG. 14 illustrates a wireless communication circuit according to embodiments.
FIG. 15 illustrates a transmit coil of FIG. 14 according to embodiments.

### DETAILED DESCRIPTION

Hereinafter, embodiments according to the present disclosure will be described clearly and in detail such that those skilled in the art may easily reproduce the present disclosure.

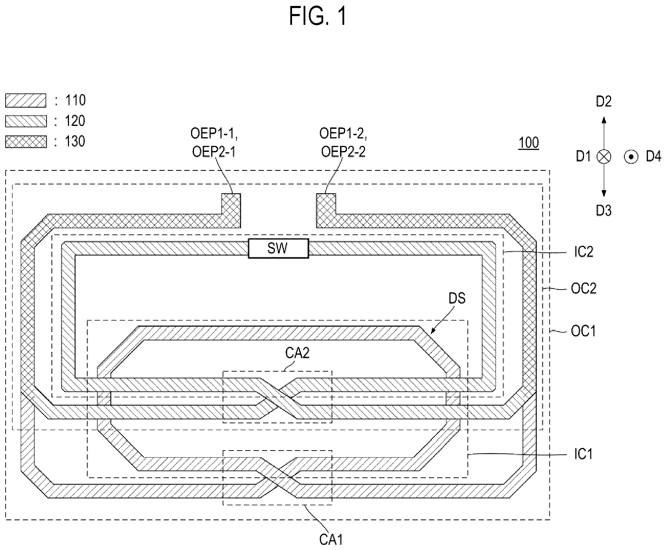

FIG. 1 illustrates a switchable coil according to embodiments.

Referring to FIG. 1, a switchable coil 100 according to embodiments may include a first coil 110, a second coil 120, and a switch SW connected to the second coil 120 to switch the second coil 120. Hereinafter, according to the present disclosure, a first direction D1 may be defined when viewed in a planar view (e.g., the planar view may be in the first direction D1), a second direction D2, which is a direction perpendicular to the first direction D1, may be an extending direction of an outer end portion and an inner end portion formed in each of the first coil 110 and the second coil 120, a third direction D3 may be a direction opposite to the second direction D2, and/or a fourth direction D4 may be a direction in which each of the first coil 110 and the second coil 120 is stacked. In addition, each of the first coil 110 and the second coil 120 may be referred to using terminology such as a winding or an inductor.

The first coil 110 may be defined as having a first inductor, and the second coil 120 may be defined as having a (2-1)-th inductor and a (2-2)-th inductor which may be connected or disconnected in response to the switch SW.

Each of the first coil 110 and the second coil 120 may include an inner coil and an outer coil when viewed from the first direction D1. The first coil 110 may include a first outer coil OC1 and a first inner coil IC1 provided inside the first outer coil OC1 when viewed in the first direction D1, and the second coil 120 may include a second outer coil OC2 and a second inner coil IC2 provided inside the second outer coil OC2 when viewed from the first direction D1. When viewed in terms of at least the first outer coil OC1, remaining coils (the first inner coil IC1, the second outer coil OC2, and the second inner coil IC2) may be provided inside the first outer coil OC1.

When viewed in the first direction D1, the first outer coil OC1 and the second outer coil OC2 may be overlapped within a specific region. According to embodiments, in an overlap region 130, the second outer coil OC2 may be provided in a layer higher than the first outer coil OC1.

According to embodiments, when viewed in the first direction D1, the first outer coil OC1 and the second outer coil OC2 may be completely overlapped with each other in the overlap region 130. Accordingly, as compared to a structure in which coils are not overlapped with each other, the present disclosure may minimize (or reduce) magnetic coupling and parasitic capacitance components between the first coil 110 and the second coil 120 in the overlap region 130.

According to embodiments, the first outer coil OC1 may include a (1-1)-th outer end portion OEP1-1 (also referred to herein as a first outer end portion) and a (1-2)-th outer end portion OEP1-2 (also referred to herein as a second outer end portion) extending in the second direction D2 perpendicular to the first direction D1. Likewise, the second outer coil OC2 may include a (2-1)-th outer end portion OEP2-1 (also referred to herein as a third outer end portion) extending in the second direction D2 and a (2-2)-th outer end portion OEP2-2 (also referred to herein as a fourth outer end portion) extending in the second direction D2. As described above, since the first outer coil OC1 and the second outer coil OC2 are overlapped with each other in the overlap region 130, the (2-1)-th outer end portion OEP2-1 may be overlapped with the (1-1)-th outer end portion OEP1-1, and the (2-2)-th outer end portion OEP2-2 may be overlapped with the (1-2)-th outer end portion OEP1-2.

According to the present disclosure, the terminology 'end portion' refers to a portion at which each coil is ended, and a plurality of end portions may be defined for each coil. Among the end portions, an end portion corresponding to the form in which a portion of a closed loop is open, may be defined as an 'open end portion'.

The second inner coil IC2 may include a first inner end portion and a second inner end portion extending in the second direction D2.

According to embodiments, the first inner coil IC1 may form a first crossing-region CA1, together with the first outer coil OC1. The second inner coil IC2 may form a second crossing-region CA2, together with the second outer coil OC2. As the first crossing-region CA1 and the second crossing-region CA2 are formed, the number of windings of the first coil 110 and the number of windings of the second coil 120 may be '2', as illustrated. In addition, each inner coil and a relevant (e.g., corresponding) outer coil may be connected to each other through a relevant crossing-region which is formed.

The first outer coil OC1 and the second outer coil OC2 may have the form in which a portion of a closed loop (or a closed curve) is open to increase inductance and/or utilize a chip area at the maximum, or at higher, spatial efficiency (e.g., conserve chip area). In addition, as the first crossing-region CA1 and the second crossing-region CA2 are formed, the first inner coil IC1 and the second inner coil IC2 may have the form of a closed loop (or a closed curve). However, for the second inner coil IC2, when viewed without the switch SW, the second inner coil IC2 may be viewed as having the form in which a portion of the closed loop (or the closed curve) is open.

According to embodiments, the second crossing-region CA2 may be provided inside the first inner coil IC1 when viewed from the first direction D1. Accordingly, a partial segment of the second outer coil OC2 and a partial segment of the second inner coil IC2 extending from the second crossing-region CA2 may also be provided inside the first inner coil IC1. Accordingly, when viewed from the first direction D1, the switchable coil 100 according to the present disclosure may have a structure in which a partial region of the second coil 120 crosses the first inner coil IC1 of the first coil 110.

Since the switchable coil 100 according to the present disclosure has a structure in which the partial region of the second coil 120 is provided in the first inner coil IC1 according to the above-described examples, a region, in which magnetic fluxes generated from currents flowing through the coils are canceled from each other, may be formed. Specifically, when a current is applied to the switchable coil 100, currents in opposite directions may flow through the first coil 110 and the second coil 120 in a region in which the first coil 110 and the second coil 120 face each other in the second direction D2 or the third direction D3. In other words, magnetic fluxes may be canceled from each other between a partial region of the first coil 110 and a partial region of the second coil 120.

When the first coil 110 and the second coil 120 are adjacent to each other, magnetic coupling may be formed between the first coil 110 and the second coil 120. According to embodiments of the present disclosure, when magnetic fluxes, in the region in which the coils are adjacent to each other, are cancelled from each other, the magnetic coupling and the mutual inductance may be reduced in the region. Accordingly, in the switching operation of the switchable coil 100, inductance may be changed many times, such that a bandwidth and a Q value (e.g., a quality value) of the coil may be increased. In addition, as the Q value increases, a gain loss may be reduced.

According to embodiments, the second crossing-region CA2 may be spaced apart from the first crossing-region CA1 by a specific distance in the second direction D2, when viewed from the first direction D1. Alternatively, the second crossing-region CA2 may be spaced apart from a divided segment DS, which is closer to the switch among divided regions of the first inner coil IC1 divided by the second inner coil IC2, by a specific distance in the second direction D2, when viewed in the first direction D1. In other words, the first inner coil IC1 may be spaced apart from regions (e.g., the second crossing-region CA2) of the second coil 120 crossing the first inner coil IC1 by a specific distance, to reduce the magnetic coupling. Accordingly, the magnetic coupling components and the parasitic capacitance components may be minimized (or reduced) between the first coil 110 and the second coil 120 in the overlap region.

The switch SW may be connected to a region, which faces the second crossing-region CA2, in the second inner coil IC2. In particular, the switch SW may be provided adjacent to the open end portions including the (1-1)-th outer end portion OEP1-1 and the (1-2)-th outer end portion OEP1-2. In other words, the switch SW may be provided more externally, when viewed in terms of the first inner coil IC1. Alternatively, the switch SW may be provided to be spaced apart from the first inner coil IC1, the first crossing-region CA1, some segments of the first coil 110 extending from the first crossing-region CA1, and some segments of the second coil 120 extending from the second crossing-region CA2 in the second direction D2.

As the switch SW is provided to be closer to the open end portion according to the above-described examples, the switch SW may be less affected by the magnetic coupling caused between the first inner coil IC1 and coils adjacent to the first inner coil IC1.

In addition, as the switch SW is provided outside the first inner coil IC1 according to embodiments, the crossing portion between coils may be reduced, as compared to which the switch SW is provided inside the first inner coil IC1. According to embodiments, the reduction in the crossing portion may result in reduced magnetic coupling.

The switch SW may be connected to the first inner end portion and the second inner end portion of the second inner coil IC2 described above. The switch SW may be turned on or off to connect or disconnect the first inner end portion and the second inner end portion to or from each other. The inductance may be changed in components to be connected to the switchable coil 100, as the switch SW is turned on or off. In other words, a component to which the switchable coil 100 is connected may have a wider bandwidth.

According to examples described above, the switchable coil 100 according to the present disclosure may have a structure in which the second crossing-region CA2 of the second coil 120 and partial segments of the second coil 120 extending from the second crossing-region CA2 are provided inside the first inner coil IC1, and the structure in which the switch SW is adjacent to the open end portion. Through these structures, the switchable coil 100 according to the present disclosure may cancel the magnetic flux between coils and may minimize (or reduce) the magnetic coupling, thereby increasing the bandwidth, the Q value of the coil, and the gain.

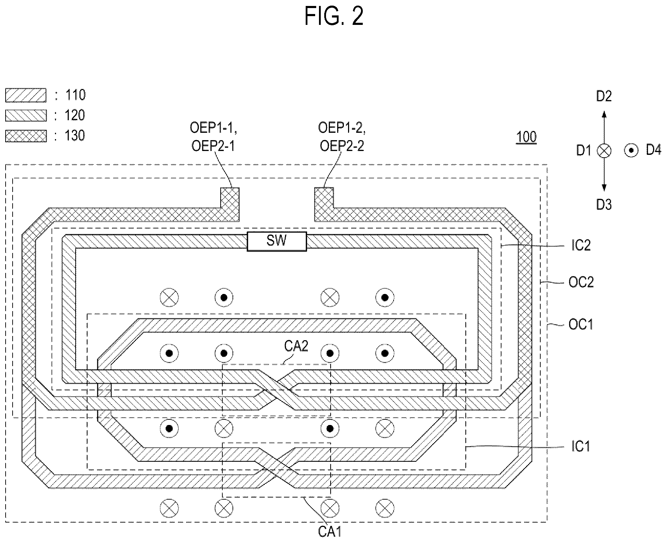

FIG. 2 illustrates a magnetic flux canceling region of the switchable coil of FIG. 1.

Referring to FIG. 2, the switchable coil 100 has the structure according to examples described above. Accordingly, the region (magnetic flux canceling region), in which the magnetic fluxes are canceled from each other, may be formed. As illustrated in FIG. 2, the flowing direction of a current in the switchable coil 100 is assumed as being a direction from the (1-1)-th outer end portion OEP1-1 to the (1-2)-th outer end portion OEP1-2 (or a direction from the (2-1)-th outer end portion OEP2-1 to the (2-2)-th outer end portion OEP2-2). Alternatively, when viewed from the first direction D1, a region having no coil is defined as being a 'substrate region'.

For the second coil 120, a magnetic flux by the first inner coil IC1 and the magnetic flux by the second inner coil IC2 are provided in the fourth direction D4 in a first substrate region, which is defined as an overlap region between the first inner coil IC1 and the second inner coil IC2, when viewed from the second crossing-region CA2. In a second substrate region defined as a region opposite to the first substrate region when viewed from (e.g., with respect to) the second crossing-region CA2 in the first inner coil IC1, the magnetic flux by the first inner coil IC1 and the magnetic flux by the second inner coil IC2 are provided in opposite directions. Accordingly, the magnetic fluxes by the first inner coil IC1 and the second inner coil IC2 may be canceled from each other in the second substrate region.

In a third substrate region defined as an external region of the first outer coil OC1, the magnetic flux by the first inner coil IC1 and the magnetic flux by the second inner coil IC2 are provided in the first direction D1. In the fourth substrate region defined as a remaining region except for the first substrate region inside the second inner coil IC2, the magnetic flux by the first inner coil IC1 and the magnetic flux by the second inner coil IC2 are provided in opposite directions. Accordingly, the magnetic fluxes by the first inner coil IC1 and the second inner coil IC2 may be canceled from each other in the fourth substrate region.

Remaining substrate regions except for the third substrate region among the first substrate region to the fourth substrate region may be regions having stronger magnetic coupling, as the first coil 110 is slightly adjacent to the second coil 120. In other words, according to embodiments of the present disclosure, the switchable coil 100 may have the structure in which magnetic fluxes are canceled in more regions (the second substrate region and the fourth substrate region) in which the magnetic coupling is generated. Accordingly, according to the present disclosure, the switchable coil 100 may have the change in inductance more times in switching by reducing the mutual inductance. Accordingly, the bandwidth and the Q value may be increased.

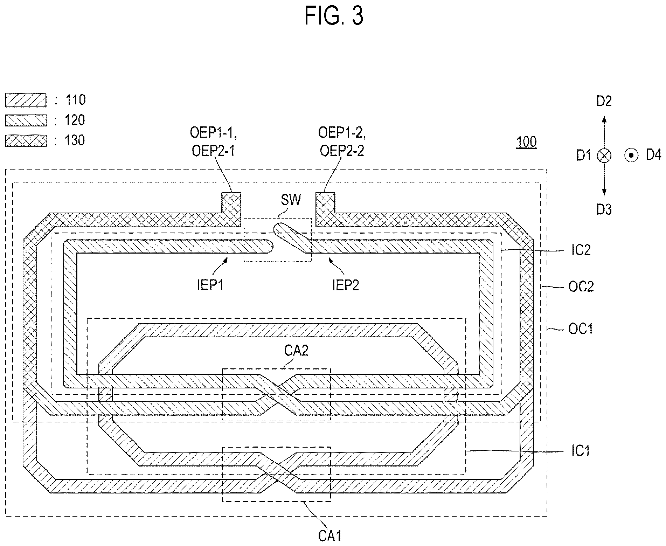

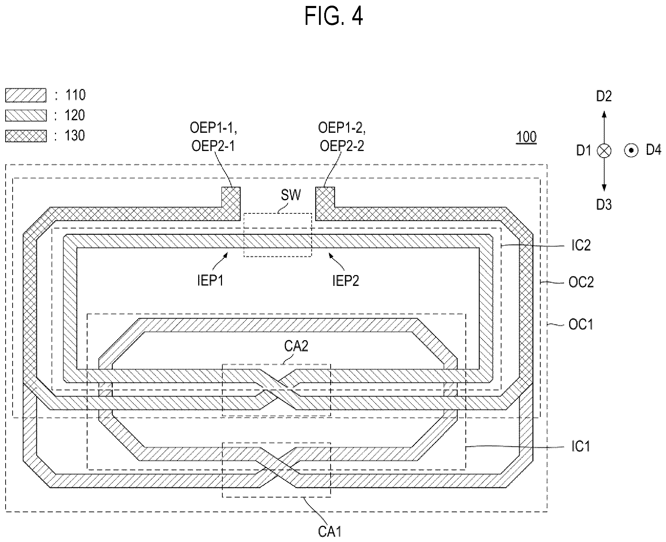

FIGS. 3 and 4 illustrate switching operations of the switchable coil of FIG. 1.

Referring to FIGS. 3 and 4, the switch SW may be turned on or off in response to a control signal. According to embodiments, the switch SW may be turned off as illustrated in FIG. 3, thereby disconnecting the first inner end portion IEP1 from the second inner end portion IEP2. In other words, the second inner coil IC2 may have the form of a closed loop partially open. When the switch SW is turned off, the second coil 120 may be expressed with a (2-1)-th inductor and a (2-2)-th inductor, which are separated from each other. Accordingly, only a first inductor corresponding to the first coil 110 may exist in an entire equivalent circuit of the switchable coil 100.

According to embodiments, the switch SW may be turned on as illustrated in FIG. 4, thereby connecting the first inner end portion IEP1 to the second inner end portion IEP2. In other words, the second inner coil IC2 may have the form of a closed loop, which is different from the first inner coil IC1. When the switch SW is turned on, the second coil 120 may be expressed with the (2-1)-th inductor and the (2-2)-th inductor which are connected each other. Accordingly, in the entire equivalent circuit of the switchable coil 100, the first inductor is connected in parallel to the second inductor including the (2-1)-th inductor and the (2-2)-th inductor connected in series to each other.

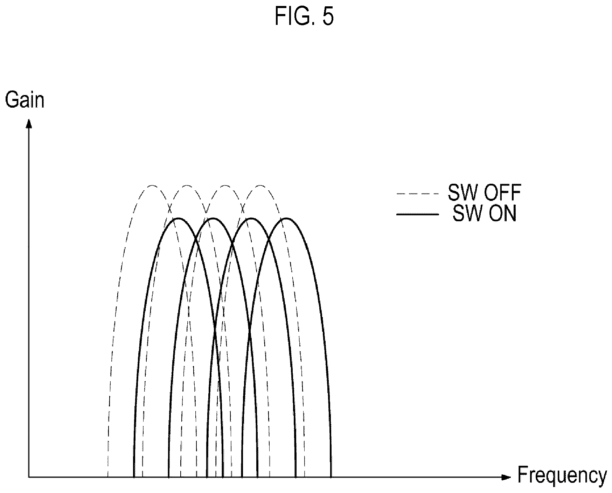

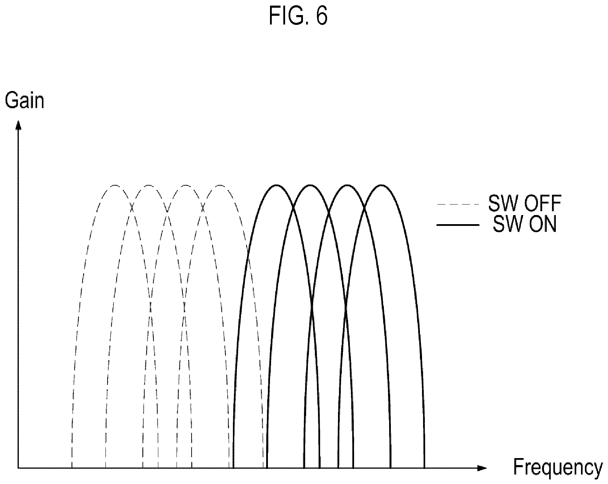

FIGS. 5 and 6 illustrate ideal frequency characteristics of a switchable coil according to embodiments. FIG. 5 is a frequency characteristic of a structure in which a switch is positioned inside an inner coil. FIG. 6 is a frequency characteristic of a switchable coil according to embodiments of the present disclosure. According to embodiments, when the switch is turned on, the inductance of the switchable coil may be reduced. Accordingly, the frequency characteristic of the switchable coil may move to the lower band. In addition, when the switch is turned off, the inductance of the switchable coil may be increased, and the frequency characteristic may move to the higher band.

First, referring to FIG. 5, when the switch is positioned inside the inner coil, magnetic coupling may be increased as compared to the present disclosure. When the larger magnetic coupling is expressed, the mutual inductance is increased. Accordingly, the variation width of the inductance may be decreased according to the switching operation. Accordingly, the bandwidth may be decreased as illustrated in FIG. 5. In addition, when the larger magnetic coupling is expressed, the Q value of the coil is decreased. Accordingly, even the gain may be deteriorated.

Referring to FIG. 6, according to embodiments, the switchable coil 100 has the second crossing-region provided inside the first inner coil and the structure in which the switch is close to the open end portion, thereby minimizing (or reducing) the magnetic coupling. When the magnetic coupling is minimized (or reduced), the mutual inductance is decreased. Accordingly, the variation width of the inductance may be decreased according to the switching operation. Accordingly, the bandwidth may be increased as illustrated in FIG. 6. In addition, as the magnetic coupling is minimized (or reduced), the Q value of the coil may be increased, and the loss of the gain may be minimized (or reduced).

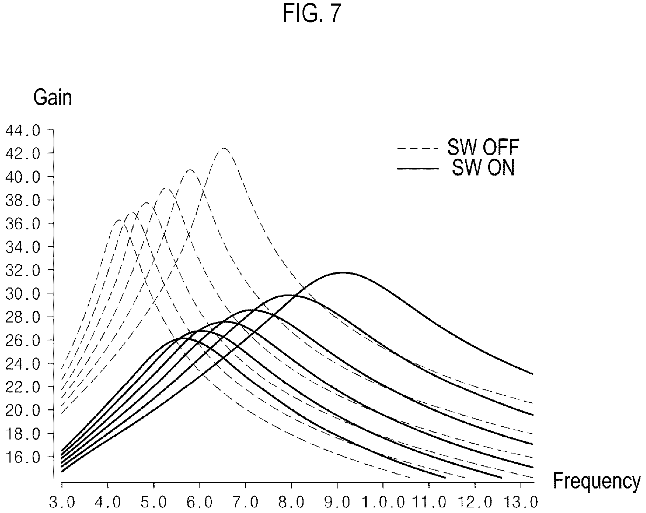

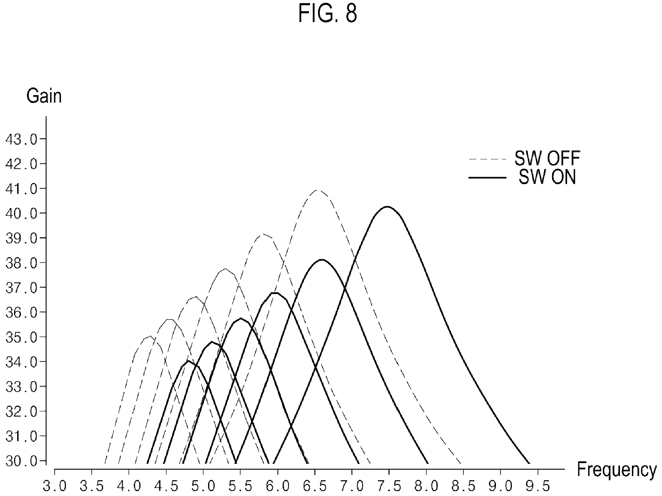

FIGS. 7 and 8 illustrate frequency characteristics based on the simulation result of a switchable coil according to embodiments. FIG. 7 is a frequency characteristic of a structure in which a switch is positioned inside an inner coil. FIG. 8 is a frequency characteristic of a switchable coil according to embodiments of the present disclosure.

Referring to FIGS. 7 and 8, similar to the ideal frequency characteristics of FIGS. 5 and 6, respectively, the frequency characteristics may be shifted, as the switch is turned on or off. First, in FIG. 7, when the switch is positioned inside the inner coil, as magnetic coupling is increased, the Q value of the coil may be decreased and the gain may be decreased, when compared with the present disclosure. In addition, unlike the ideal case, the larger gain difference is made due to loss between the cases where the switch is turned on and off, thereby making it difficult to define the bandwidth in both cases.

Also, as illustrated in FIG. 8, as the magnetic coupling is decreased, the Q value of the coil may be maintained, thereby minimizing (or reducing) gain deterioration and changing the frequency characteristics, as the switch is turned on/off.

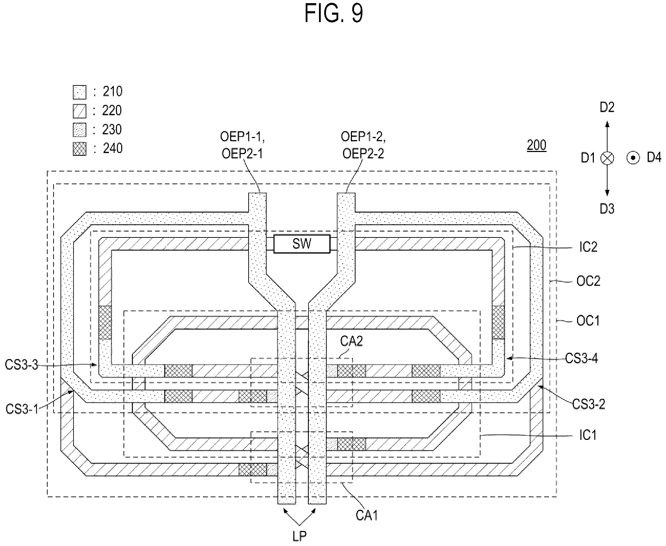

FIG. 9 illustrates a metal structure of a switchable coil according to embodiments.

Referring to FIG. 9, a switchable coil 200 according to embodiments may include first to third metals 210 to 230. The third metal 230, the second metal 220, and the first metal 210 may be sequentially stacked in the fourth direction D4. In other words, the third metal 230 may be stacked in a lower layer, and the first metal 210 may be stacked in an upper layer.

First, the first outer coil OC1 and the first inner coil IC 1 may include the second metal 220. However, the first crossing-region CA1 formed by the first outer coil OC1 and the first inner coil IC1 may include the second metal 220 and the third metal 230. In the first crossing-region CA1, a (1-1)-th crossing segment, which includes the third metal 230 and is stacked on a lower layer, may be connected to the first outer coil OC1 and the first inner coil IC1 including the second metal 220 through a via 240. A (1-2)-th crossing segment may include the second metal 220 and may be stacked on the (1-1)-th crossing segment.

The second outer coil OC2 and the second inner coil IC2 may include the first metal 210 and the second metal 220. However, the second crossing-region CA2 formed by the second outer coil OC2 and the second inner coil IC2 may include the second metal 220 and the third metal 230, which is similar to the first crossing-region CA1. In the second crossing-region CA2, a (2-1)-th crossing segment, which includes the third metal 230 and is stacked in a lower layer, may be connected to the second outer coil OC2 and the second inner coil IC2 including the second metal 220 through the via 240. A (2-2)-th crossing segment may include the second metal 220 and may be stacked on the (2-1)-th crossing segment.

According to embodiments, when viewed in the first direction D1, the second outer coil OC2 may be overlapped with the first outer coil OC1 in the overlap region. The second outer coil OC2 corresponding to the overlap region may include the first metal 210.

According to embodiments, since at least a portion of the second outer coil OC2 is provided inside the first inner coil IC1, a crossing (or overlap) region with the first inner coil IC1 is present. When the region of the second outer coil OC2 corresponding to the relevant crossing-region is defined as a (3-1)-th crossing segment CS3-1 and a (3-2)-th crossing segment CS3-2, the (3-1)-th crossing segment CS3-1 and the (3-2)-th crossing segment CS3-2 may include the first metal 210 similarly to the overlap region. The (3-1)-th crossing segment CS3-1 and the (3-2)-th crossing segment CS3-2 may be connected to the second outer coil OC2 including the second metal 220 through the via 240.

Similarly, since at least a portion of the second inner coil IC2 is provided inside the first inner coil IC1, a crossing (or overlap) region with the first inner coil IC1 is present. When the region of the second inner coil IC2 corresponding to the relevant crossing-region is defined as a (3-3)-th crossing segment CS3-3 and a (3-4)-th crossing segment CS3-4, the (3-3)-th crossing segment CS3-3 and the (3-4)-th crossing segment CS3-4 may include the first metal 210. The (3-3)-th crossing segment CS3-3 and the (3-4)-th crossing segment CS3-4 may be connected to the second inner coil IC2 including the second metal 220 through the via 240.

The (2-1)-th outer end portion OEP2-1 and the (2-2)-th outer end portion OEP2-2 included in the second outer coil OC2 may include the first metal 210. The line pair LP connected to the (2-1)-th outer end portion OEP2-1 and the (2-2)-th outer end portion OEP2-2 may include the first metal 210, similarly to the outer end portion. In addition, the (1-1)-th outer end portion OEP1-1 and the (1-2)-th outer end portion OEP1-2 stacked in the lower layers of the (2-1)-th outer end portion OEP2-1 and the (2-2)-th outer end portion OEP2-2 may include the second metal 220.

The switch SW may be connected to a first inner end portion and a second inner end portion including the second metal 220 in the second inner coil IC2. The regions of the second inner coil IC2 including the second metal 220 may be connected to each other depending on the switching operation of the switch SW.

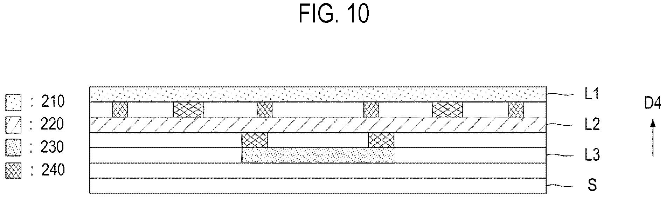

FIG. 10 is a stacked view of a metal structure of the switchable coil of FIG. 9.

Referring to FIG. 10, the switchable coil 200 according to embodiments may be stacked on a semiconductor substrate "S". For example, the switchable coil 200 may be fabricated using a complementary metal-oxide semiconductor (CMOS) process

According to embodiments, a third layer L3 including the third metal 230 is formed on the semiconductor substrate "S", a second layer L2 including the second metal 220, and a first layer L1 including the first metal 210 may be sequentially stacked in the fourth direction D4. In addition, although not illustrated, a ground electrode may be formed under the semiconductor substrate "S".

In addition, at least one interlayer insulating layer may be interposed between the semiconductor substrate "S" and the third layer L3, between the third layer L3 and the second layer L2, and between the second layer L2 and the first layer L1. For example, the interlayer insulating layer may include a silicon oxide (SiOx), a silicon oxynitride (SiOxNy), a silicon nitride (SiNx), a germanium oxynitride (GeOxNy), a germanium silicon oxide (GeSixOy), or a material having a high dielectric constant. The high dielectric constant material may include a hafnium oxide (HfOx), a zirconium oxide (ZrOx), an aluminum oxide (AlOx), a tantalum oxide (TaOx), a hafnium silicate (HfSix), or a zirconium silicate (ZrSix). In addition, according to embodiments, the interlayer insulating layer may be formed in a multilayer structure including at least two materials selected from among the above-described materials

According to embodiments, the first metal 210 to the third metal 230 may include a conductive material. For example, the conductive material may include a metal such as copper, tungsten, titanium, or aluminum, or may include polysilicon, metal, and/or metal compounds. According to embodiments, at least two among the first metal 210 to the third metal 230 may include the same conductive material. According to embodiments, at least two among the first metal 210 to the third metal 230 may include the different conductive materials. For example, the first outer coil OC1 may include a different conductive material (e.g., a different metal) from the second outer coil OC2 in the specific region in which the first outer coil OC1 and the second outer coil OC2 overlap.

The third layer L3 may include a (1-1)-th crossing segment and a (2-1)-th crossing segment including the third metal 230. The (1-1)-th crossing segment and the (2-1)-th crossing segment may be connected to the second metal 220 provided in the second layer L2 through the via 240. According to embodiments, while referred to herein in the singular form "via 240," the via 240 may also be interpreted as including a plurality of vias 240 in different physical positions.

The second layer L2 may include a first outer coil, a first inner coil, a second outer coil, a second inner coil, a (1-2)-th crossing segment, or a (2-2)-th crossing segment including the second metal 220 according to the examples described above. The second metal 220 may be connected to the first metal 210 provided in the first layer L1 through the via 240.

The first layer L1 may include a (3-1)-th crossing segment to a (3-4)-th crossing segment including the first metal 210, and a line pair. The (3-1)-th crossing segment to the (3-4)-th crossing segment may be connected to the second metal 220 provided in the second layer L2 through the via 240. Similarly, the line pair may be connected to the second metal 220 provided in the second layer L2 through the via 240.

According to embodiments, as the second metal 220 constituting the first outer coil and the first metal 210 constituting the second outer coil may be provided in different layers (the second layer L2 and the first layer L1) in the overlap region, the second metal 220 and the first metal 210 may be spaced apart from each other in the fourth direction D4 while being overlapped with each other. Accordingly, as compared to the structure in which the coils are not overlapped with each other, the present disclosure may minimize (or reduce) the magnetic coupling and the parasitic capacitance component between the first coil and the second coil.

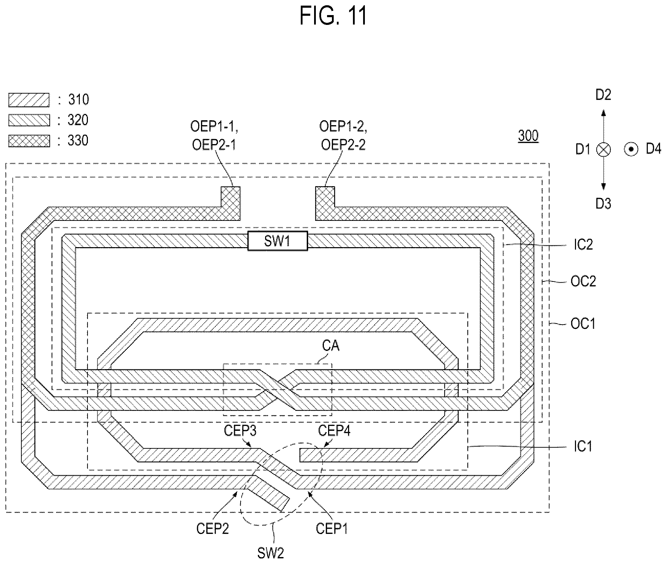

FIG. 11 illustrates a metal structure of a switchable coil according to embodiments. In the following description, redundant details associated with the switchable coil described above will be omitted.

Referring to FIG. 11, according to embodiments, a switchable coil 300 may include a first coil 310, a second coil 320, a first switch SW1, and/or a second switch SW2.

The first coil 310 may include the first outer coil OC1 and the first inner coil IC1. According to embodiments, the first outer coil OC1 may include a first crossing end portion CEP1 and a second crossing end portion CEP2 opposite to the (1-1)-th outer end portion OEP1-1 and the (1-2)-th outer end portion OEP1-2 extending in the second direction D2. For example, the first crossing end portion CEP1 and the second crossing end portion CEP2 may be provided at positions corresponding to the first crossing-region CA1 illustrated in FIGS. 1 to 4 and 9 described above.

The first inner coil IC1 may include a third crossing end portion CEP3 and a fourth crossing end portion CEP4 facing the first switch SW1. For example, the third crossing end portion CEP3 and the fourth crossing end portion CEP4 may be provided at positions corresponding to the first crossing-region CA1 illustrated in FIGS. 1 to 4, and FIG. 9 described above. The third crossing end portion CEP3 may be connected to the first crossing end portion CEP1 through the crossing segment. For example, the crossing segment may correspond to the (1-2)-th crossing segments illustrated in FIGS. 1 to 4 and FIG. 9 described above. The first outer coil OC1 and the first inner coil IC1 may remain connected to each other through the crossing segment. According to embodiments, the crossing segment may be provided on the second switch SW2. In other words, the crossing segment may be provided in an upper layer (e.g., with respect to the fourth direction D4) of the second switch SW2.

The second coil 320 may include the second outer coil OC2 and the second inner coil IC2 forming the crossing-region CA, which is provided inside the first inner coil IC1, together with the second outer coil OC2 when viewed in the first direction D1.

The first switch SW1 may be connected to a region facing the crossing-region CA inside the second inner coil IC2. As the first switch SW1 is turned on based on the first control signal, the first inner end portion and the second inner end portion formed in the first inner coil IC1 may be connected to each other.

The second switch SW2 may be connected to the second crossing end portion CEP2 and the fourth crossing end portion CEP4. In other words, even the second switch SW2 may be provided at a position corresponding to the first crossing-region CA1 illustrated in FIGS. 1 to 4, and FIG. 9 described above, which is similar to the second crossing end portion CEP2 and the fourth crossing end portion CEP4. The first switch SW1 and the second switch SW2 may face each other toward the crossing-region CA, and the crossing-region CA may be interposed between the first switch SW1 and the second switch SW2 .

As the second switch SW2 is turned on in response to a second control signal, the second switch SW2 may connect the second crossing end portion CEP2 to the fourth crossing end portion CEP4. When the second switch SW2 is turned on, the whole structure of the switchable coil 100 is the same as (or similar to) the structure as illustrated in FIG. 1. In other words, as the first crossing end portion CEP1 and the third crossing end portion CEP3 are connected to each other, and the second crossing end portion CEP2 and the fourth crossing end portion CEP4 are connected to each other, the first crossing-region CA1 of FIG. 1 may be formed. Alternatively, as the second switch SW2 is turned off in response to the second control signal, the second crossing end portion and the fourth crossing end portion CEP4 may be disconnected from each other.

According to embodiments, the switchable coil 300 may adjust inductance through the first switch SW1 and the second switch SW2. The first coil 310 may be expressed with an (1-1)-th inductor and a (1-2)-th inductor which may be connected through the second switch SW2, and the second coil 320 may be expressed with the (2-1)-th inductor and the (2-2)-th inductor which may be connected to each other through the first switch SW1.

Specifically, when both the first switch SW1 and the second switch SW2 are turned off, the (1-1)-th inductor and the (1-2)-th inductor may be disconnected from each other, and the (2-1)-th inductor and the (2-2)-th inductor may also be disconnected from each other. Accordingly, the frequency characteristic of the switchable coil 300 may show (e.g., correspond to) the lowest band (or a lower band).

Specifically, when the first switch SW1 is turned on and the second switch SW2 is turned off, the (1-1)-th inductor and the (1-2)-th inductor may be connected to each other, and the (2-1)-th inductor and the (2-2)-th inductor may also be connected to each other. Accordingly, the frequency characteristic of the switchable coil 300 may show (e.g., correspond to) the higher band (or a higher band than that shown when both the first switch SW1 and the second switch SW2 are turned off).

Next, when both the first switch SW1 and the second switch SW2 are turned on, all inductors may be connected to each other. Accordingly, the frequency characteristic of the switchable coil 300 may show (e.g., correspond to) the highest band (or a higher band than that shown when the first switch SW1 is turned on and the second switch SW2 is turned off).

According to embodiments, the switchable coil 300 according to the present disclosure includes an additional switch SW, such that inductances and frequency characteristics may be adjusted in a wider range.

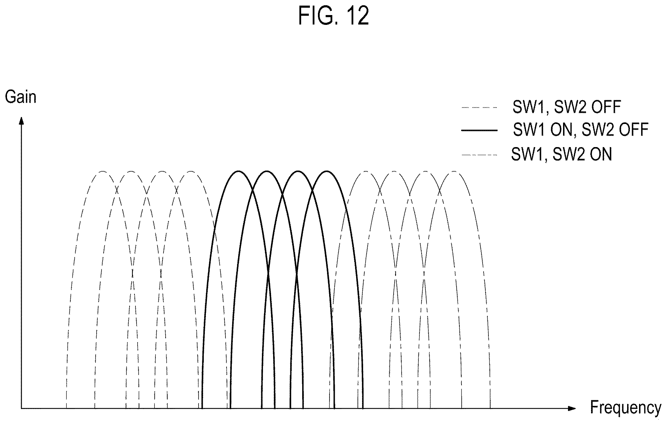

FIG. 12 illustrates the ideal frequency characteristic of the switchable coil illustrated in FIG. 11.

Referring to FIG. 12, the switchable coil of FIG. 11 may vary inductances in a wider range through a first switch and a second switch. Accordingly, the switchable coil may have a wider frequency band.

For example, when both the first switch and the second switch are turned off, the frequency characteristic of the switchable coil may be positioned in the lowest band. Next, when the first switch is turned on and the second switch is turned off, the frequency characteristic may move to the higher band, as the inductance is further reduced. Finally, when the first switch and the second switch are turned on, the frequency characteristic may move to the highest band, as the inductance is reduced at the maximum (or to a largest extent).

In addition, the switchable coil may increase the Q value and reduce the loss by reducing the magnetic coupling and the parasitic capacitance components through the structures according to the examples described above. Accordingly, the gain loss may be minimized (or reduced) in the ideal frequency characteristic.

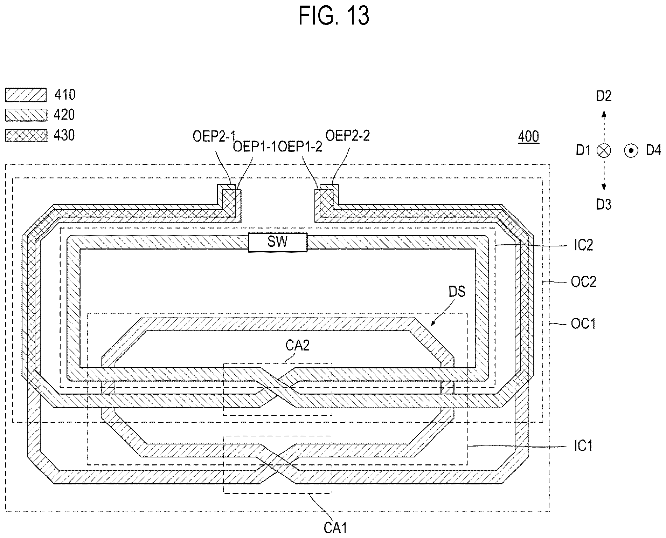

FIG. 13 illustrates a switchable coil according to embodiments.

Referring to FIG. 13, a switchable coil 400 according to embodiments may include the first outer coil OC1 and the second outer coil OC2 which may be only partially overlapped with each other instead of being completely overlapped with each other when viewed in the first direction D1, which is different from the examples described above. Similarly, the second outer coil OC2 may be provided in a higher layer than that of the first outer coil OC1 in an overlap region 430. A region for only a second coil 420 and a region for only a first coil 410 may be present in a non-overlap region adjacent to the overlap region. While FIG. 13 depicts the non-overlapping portion of the second outer coil OC2 as being outside of the non-overlapping portion of the first outer coil OC1, embodiments are not limited thereto. According to embodiments, the non-overlapping portion of the first outer coil OC1 may be outside of the non-overlapping portion of the second outer coil OC2.

In addition, when viewed in the first direction D1, the (1-1)-th outer end portion OEP1-1 included in the first outer coil OC1 may not be completely overlapped with the (2-1)-th outer end portion OEP2-1 included in the second outer coil OC2, and the (1-2)-th outer end portion OEP1-2 included in the first outer coil OC1 may be not completely overlapped with the (2-2)-th outer end portion OEP2-2 extending in the second direction D2 and included in the second outer coil OC2.

Remaining components (the switch SW, the first inner coil IC1, the second inner coil IC2, the crossing-regions CA1 and CA2, or the divided segment DS), the shape and the effect may follow the examples described above, except that that the first outer coil OC1 and the second outer coil OC2 are not completely overlapped with each other in a specific region. Specifically, since the overlap region 430 is still present, the magnetic coupling and the parasitic capacitance component between the first coil 410 and the second coil 420 may be reduced. In addition, even the switchable coil 400 of FIG. 13 has the structure in which the second crossing-region CA2 is provided inside the first inner coil IC1 and the switch SW is close to the open end portion. Accordingly, the magnetic coupling may be minimized (or reduced), the variation in the inductance, the bandwidth, and the Q value of the coil depending on the switching may be increased, and the loss of the gain may be minimized (or reduced).

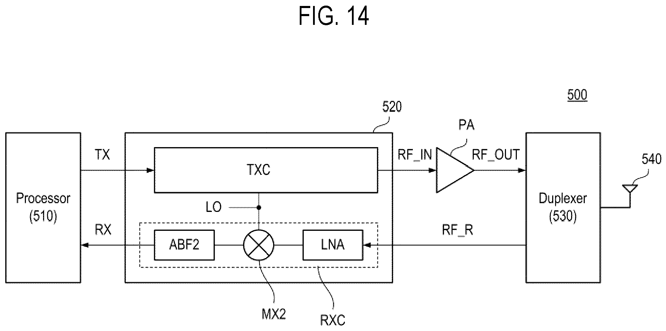

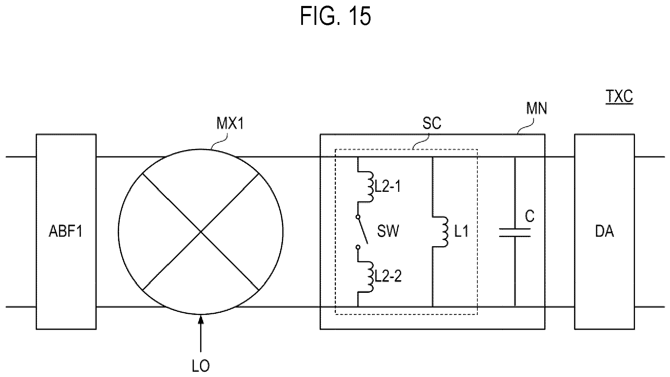

FIG. 14 illustrates a wireless communication circuit according to embodiments, and FIG. 15 illustrates the transmit coil of FIG. 14 according to embodiments.

Referring to FIG. 14, a wireless communication device 500 according to embodiments may include a processor 510, a radio frequency integrated chip (RFIC) 520, a power amplifier (PA), a duplexer 530, and/or an antenna 540.

The processor 510 may process a baseband signal including information to be transmitted according to a predetermined (or alternatively, given) communication method. For example, the processor 510 may process a signal to be transmitted or received depending on a communication scheme, such as an Orthogonal Frequency Division Multiplexing (OFDMA), an Orthogonal Frequency Division Multiple Access (OFDMA), a Wideband Code Multiple Access (WCDMA), and/or a High Speed Packet Access+ (HSPA+). In addition, the processor 510 may process a baseband signal depending on various types of communication schemes (that is, various communication schemes applied to various technologies for modulating or demodulating the amplitude and the frequency of the baseband signal).

The processor 510 may convert the baseband signal to be in the digital/analog form to generate a transmit signal TX, and output the transmit signal TX to the RFIC 520.

In addition, the processor 510 may receive a receive signal RX, which is an analog signal, from the RFIC 520. In the processor 510 may convert the receive signal RX to be in the digital/analog form to extract the baseband signal which is a digital signal. In this case, the receive signal RX may be a differential signal including a positive signal and a negative signal. According to embodiments, the processor 510 may control overall operations of the wireless communication device 500 including at least controlling the switch(es) (e.g., the switch SW, the first switch SW1 and/or the second switch SW2) by providing the control signal(s) (e.g., the control signal, the first control signal and/or the second control signal) to the switch(es).

The RFIC 520 may generate an RF input signal RF_IN by performing frequency up-conversion on the transmit signal TX or may generate the receive signal RX by performing frequency down-conversion on an RF receive signal RF_R. Specifically, the RFIC 520 may include a transmit coil TXC for frequency up-conversion, a receive circuit RXC for frequency down-conversion, and/or a local oscillator LO.

In this case, the transmit coil TXC may include a first analog baseband filter ABF1, a first mixer MX1, a matching network MN, and/or an amplifier DA. For example, the first analog baseband filter ABF1 may include a low pass filter.

The first analog baseband filter ABF1 may filter the transmit signal TX received from the processor 510 and provide the transmit signal to the first mixer MX1. For example, the first analog baseband filter ABF1 may include a low pass filter.

In addition, the first mixer MX1 may perform frequency up-conversion, which converts the frequency of the transmit signal TX from the base band to the high frequency band (e.g., RF band), based on the frequency signal provided from the local oscillator LO. Through the frequency up-conversion, the transmit signal TX may be provided to the amplifier DA while serving as the RF input signal RF_IN, and the amplifier DA may primarily power-amplify (e.g., may perform a first power amplification) the RF input signal RF_IN and provide the RF input signal RF_IN to a power amplifier PA (e.g., for performance of a second power amplification).

The matching network MN may be interposed between an output terminal of the first mixer MX1 and the amplifier DA to provide impedance matching between stages. For example, the matching network MN may be connected to an output of the first mixer MX1 and to an input of the amplifier DA.

The matching network MN according to embodiments may include at least one switchable coils SC and an equivalent capacitor C described above. The switchable coil SC may be implemented according to the above-described examples (FIGS. 1 to 13), and adjust an inductance depending on whether the switch is turned on or off. Accordingly, the inductance of the matching network MN may be varied as the switch is (or switches are) turned on or off. For example, the switchable coil SC may include a first inductor L1 expressed with the first coil described above and a (2-1)-th inductor L2-1 and a (2-2)-th inductor L2-2 expressed with the second coil. According to embodiments, consistent with the above discussion, the matching network may be configured to have an inductance that varies based on the switch being turned on or off.

The power amplifier PA may generate an RF output signal RF_OUT by secondarily amplifying the power of the RF input signal RF_IN based on the driving voltage. In addition, the power amplifier PA may provide the RF output signal RF_OUT, which is generated, to the duplexer 530.

The receive circuit RXC may include a second analog baseband filter ABF2, a second mixer MX2, and/or a low noise amplifier LNA. For example, the second analog baseband filter ABF2 may include a low pass filter.

The low noise amplifier LNA may amplify the RF receive signal RF_R provided from the duplexer 530 and provide the RF receive signal RF_R, which is amplified, to the second mixer MX2. The second mixer MX2 may perform frequency down-conversion, which converts the frequency of the RF receive signal RF_R from the higher frequency band to the base band, through the frequency signal provided by the local oscillator LO. Through the frequency down-conversion, the RF receive signal RF_R may be provided to the second analog baseband filter ABF2 while serving as the receive signal RX, and the second analog baseband filter ABF2 may filter the receive signal RX and provide the filtered receive signal RX to the processor 510

For reference, the wireless communication device 500 may transmit a transmit signal through a plurality of frequency bands through a carrier aggregation (CA) technology. In addition, to this end, the wireless communication device 500 may include a plurality of power amplifiers that power-amplify a plurality of RF input signals RF_IN corresponding to a plurality of carriers, respectively. However, according to embodiments of the present disclosure, for convenience of explanation, one power amplifier PA will be described by way of example.

The duplexer 530 may be connected to the antenna 540 to separate a transmit frequency from a receive frequency. In detail, the duplexer 530 may divide the RF output signal RF_OUT, which is provided from the power amplifier PA, based on frequency bands and may provide the RF output signal RF _OUT to the relevant antenna 540. In addition, the duplexer 530 may provide the external signal, which is provided from the antenna 540, to the low noise amplifier LNA of the receive circuit RXC of the RFIC 520. For example, the duplexer 530 may include a front end module with integrated duplexer (FEMiD). According to embodiments, after transmitting the RF output signal RF_OUT via the relevant antenna 540, the wireless communication device 500 may receive an external signal in response to the RF output signal RF_OUT. The wireless communication device 500 may process this response signal as discussed above to obtain a baseband signal, and may perform one or more further operation(s) based on the baseband signal. For example, the one or more further operation(s) may include one or more of providing the baseband signal to an application executing on the wireless communication device 500 (e.g., for performing a service based on data provided in the baseband signal), storing the baseband signal (e.g., in a memory of the wireless communication device 500), processing and transmitting a further response signal (e.g., by performing the same processing as, or similar processing to, that discussed above) based on data provided in the baseband signal, etc.

For reference, the wireless communication device 500 may include a switch structure that may separate the transmit frequency from the receive frequency, instead of the duplexer 530. In addition, the wireless communication device 500 may include the structure including the duplexer 530 and a switch to separate the transmit frequency from the receive frequency. However, for convenience of explanation, according to embodiments of the present disclosure , the following description will be made regarding that the duplexer 530 to separate the transmit frequency from the receive frequency is provided in the wireless communication device 500.

The antenna 540 may transmit the RF output signal RF_OUT, which is frequency-separated, to the outside by the duplexer 530 or may provide the RF receive signal RF_R, which is received from the outside, to the duplexer 530. For example, the antenna 540 may include an array antenna, but the present disclosure is not limited thereto.

For reference, the processor 510, the RFIC 520, the power amplifier PA, and/or the duplexer 530 may each be individually implemented as an IC, a chip, or a module. In addition, the processor 510, the RFIC 520, the power amplifier PA, and/or the duplexer 530 may be mounted together on a printed circuit board (PCB). However, embodiments the present disclosure are not limited thereto. According to embodiments, at least some of the processor 510, the RFIC 520, the power amplifier PA, and/or the duplexer 530 may be implemented in the form of a single communication chip.

Furthermore, the wireless communication device 500 illustrated in FIG. 14 may be included in a wireless communication system using a cellular network such as 5G and LTE, or may be included in a wireless local region network (WLAN) system or any other wireless communication system. For reference, the configuration of the wireless communication device 500 illustrated in FIG. 14 is provided only for illustrative purposes. The wireless communication device 500 may be variously configured depending on a communication protocol or a communication scheme.

According to the above-described examples, the wireless communication device 500 according to the present disclosure may minimize (or reduce) the gain loss of power amplification through the switchable coil SC to reduce magnetic coupling. Accordingly, the wireless communication device 500 according to the present disclosure may reduce the current of the power amplifier by improving the power gain, such that the current competitiveness may be increased.

As described above, according to the present disclosure, the switchable coil and the transmit circuit including the same may be provided.

Conventional devices and methods for extending a frequency range of a wireless device rely on incorporation of multiple transmitters. However, this incorporation of multiple transmitters involves the inclusion of additional hardware components for each of the multiple transmitters, resulting in an excessive physical area a chip devoted to supporting the multiple transmitters. Such an excessive chip size is particularly burdensome in portable wireless devices which are typically of a smaller physical size to aid in portability. Also, the additional hardware components may result in excessive resource consumption (e.g., power).

However, according to embodiments, improved devices and methods are provided for extending a frequency range of a wireless device. For example, the improved devices and methods may involve incorporation of a switchable coil and only a single transmitter rather than the multiple transmitters of the conventional devices and methods. The switchable coil may include a first coil and a second coil, and may have a structure in which magnetic fluxes are canceled in one or more regions in which magnetic coupling is created between the first and second coils. Accordingly, parasitic capacitance components between the first and second coils are minimized or reduced, resulting in increased bandwidth, an increased Q value and/or a reduction of gain loss. Thus, the switchable coil enables the extension of the frequency range without the incorporation of multiple transmitters, thereby reducing chip size. Therefore, the improved devices and methods overcome the deficiencies of the conventional devices and methods to at least reduce chip size and/or resource consumption.

According to embodiments, operations described herein as being performed by the wireless communication device 500, the processor 510, the RFIC 520, the PA, the duplexer 530, the transmit coil TXC, the receive circuit RXC, the local oscillator LO, the first analog baseband filter ABF1, the first mixer MX1, the amplifier DA, the second analog baseband filter ABF2, the second mixer MX2, and/or the low noise amplifier LNA may be performed by processing circuitry. The term `processing circuitry,' as used in the present disclosure, may refer to, for example, hardware including logic circuits; a hardware/software combination such as a processor executing software; or a combination thereof. For example, the processing circuitry more specifically may include, but is not limited to, a central processing unit (CPU), an arithmetic logic unit (ALU), a digital signal processor, a microcomputer, a field programmable gate array (FPGA), a System-on-Chip (SoC), a programmable logic unit, a microprocessor, application-specific integrated circuit (ASIC), etc.

The various operations of methods described above may be performed by any suitable device capable of performing the operations, such as the processing circuitry discussed above. For example, as discussed above, the operations of methods described above may be performed by various hardware and/or software implemented in some form of hardware (e.g., processor, ASIC, etc.).

The software may comprise an ordered listing of executable instructions for implementing logical functions, and may be embodied in any "processor-readable medium" for use by or in connection with an instruction execution system, apparatus, or device, such as a single or multiple-core processor or processor-containing system.

The blocks or operations of a method or algorithm and functions described in connection with embodiments disclosed herein may be embodied directly in hardware, in a software module executed by a processor, or in a combination of the two. If implemented in software, the functions may be stored on or transmitted over as one or more instructions or code on a tangible, non-transitory computer-readable medium (e.g., a memory of the wireless communication device 500). A software module may reside in Random Access Memory (RAM), flash memory, Read Only Memory (ROM), Electrically Programmable ROM (EPROM), Electrically Erasable Programmable ROM (EEPROM), registers, hard disk, a removable disk, a CD ROM, or any other form of storage medium known in the art.

Embodiments are described herein with reference to cross-sectional illustrations that are schematic illustrations of idealized examples. As such, variations from the shapes of the illustrations as a result, for example, of manufacturing techniques and/or tolerances, are to be expected. Thus, embodiments should not be construed as limited to the particular shapes of regions illustrated herein but are to include deviations in shapes that result, for example, from manufacturing.

It will be understood that when an element is referred to as being "connected" or "coupled" to another element, it may be directly connected or coupled to the other element or intervening elements may be present. As used herein the term "and/or" includes any and all combinations of one or more of the associated listed items.

Although terms of "first" or "second" may be used to explain various components, the components are not limited to the terms. These terms should be used only to distinguish one component from another component. For example, a "first" component may be referred to as a "second" component, or similarly, and the "second" component may be referred to as the "first" component. Expressions such as "at least one of" when preceding a list of elements, modify the entire list of elements and do not modify the individual elements of the list. For example, the expression, "at least one of a, b, and c," should be understood as including only a, only b, only c, both a and b, both a and c, both b and c, all of a, b, and c, or any variations of the aforementioned examples.

Embodiments may be described with reference to acts and symbolic representations of operations (e.g., in the form of flow charts, flow diagrams, data flow diagrams, structure diagrams, block diagrams, etc.) that may be implemented in conjunction with units and/or devices discussed in more detail herein. Although discussed in a particular manner, a function or operation specified in a specific block may be performed differently from the flow specified in a flowchart, flow diagram, etc. For example, functions or operations illustrated as being performed serially in two consecutive blocks may actually be performed concurrently, simultaneously, contemporaneously, or in some cases be performed in reverse order.

The above description refers to detailed examples for carrying out the present disclosure. Embodiments in which a design is changed simply or which are easily changed may be included in the present disclosure as well as the examples described above. In addition, technologies that are easily changed and implemented by using the above examples may be included in the present disclosure.

Embodiments are set out in the following clauses:
Clause 1. A switchable coil comprising:
   a first coil including a first outer coil and a first inner coil, the first inner coil and the first outer coil forming a first crossing-region;
   a second coil including a second outer coil and a second inner coil, the second inner coil and the second outer coil forming a second crossing-region, and the second crossing-region being inside the first inner coil viewed in a first direction; and
   a switch connected to a region facing the second crossing-region in the second inner coil.
Clause 2. The switchable coil of clause 1, wherein a number of windings of the first coil and a number of windings of the second coil is two.
Clause 3. The switchable coil of clause 1 or 2, wherein
   the first outer coil includes a first outer end portion and a second outer end portion each extending in a second direction perpendicular to the first direction; and
   the second outer coil includes a third outer end portion and a fourth outer end portion, the third outer end portion being overlapped with the first outer end portion, and the fourth outer end portion being overlapped with the second outer end portion.
Clause 4. The switchable coil of any preceding clause, wherein the second outer coil includes:
   a first inner end portion and a second inner end portion each extending in a second direction perpendicular to the first direction, the switch being connected to the first inner end portion and the second inner end portion.
Clause 5. The switchable coil of any preceding clause, wherein the switch is configured to:
   connect the first inner end portion to the second inner end portion based on the switch being turned on in response to a control signal.
Clause 6. The switchable coil of clause 5, wherein the switch is configured to:
   disconnect the first inner end portion from the second inner end portion based on the switch being turned off in response to the control signal.
Clause 7. The switchable coil of any preceding clause, wherein the switch and the first crossing-region are outside the second crossing-region viewed in the first direction.
Clause 8. The switchable coil of any preceding clause, wherein the second crossing-region is spaced apart from the first crossing-region by a first distance in a second direction perpendicular to the first direction.
Clause 9. The switchable coil of any preceding clause, wherein the first outer coil is overlapped with the second outer coil in a first region viewed in the first direction.
Clause 10. The switchable coil of any preceding clause, wherein the first outer coil includes a different metal from the second outer coil in the first region.
Clause 11. The switchable coil of any preceding clause, wherein
   the first inner coil is inside the first outer coil viewed in the first direction; and
   the second inner coil is inside the second outer coil viewed in the first direction.
Clause 12. A switchable coil comprising:
   a first coil including a first outer coil and a first inner coil, the first outer coil including a first crossing end portion and a second crossing end portion, the first inner coil including a third crossing end portion and a fourth crossing end portion, and the third crossing end portion being connected to the first crossing end portion through a crossing segment;
   a second coil including a second outer coil and a second inner coil, the second outer coil and the second inner coil forming a crossing-region, and the crossing-region being provided inside the first inner coil viewed in a first direction;
   a first switch connected to a first region facing the crossing-region in the second inner coil; and
   a second switch connected to the second crossing end portion and the fourth crossing end portion.
Clause 13. The switchable coil of clause 12, wherein the first outer coil is overlapped with the second outer coil in a second region viewed in the first direction.
Clause 14. A transmit circuit comprising:
   a mixer configured to perform up-conversion of a transmit signal based on a local oscillator (LO) signal; and
   a matching network connected to an output of the mixer, the matching network including at least one switchable coil, and the switchable coil including
      a first coil including a first outer coil and a first inner coil, the first outer coil and the first inner coil forming a first crossing-region,
      a second coil including a second outer coil and a second inner coil, the second outer coil and the second inner coil forming a second crossing-region, and the second crossing-region being inside the first inner coil viewed in a first direction, and
      a switch connected to a first region facing the second crossing-region in the second inner coil.
Clause 15. The transmit circuit of clause 14, wherein the matching network is configured to have an inductance that varies based on the switch being turned on or off.

While the present disclosure has been described with reference to embodiments thereof, it will be apparent to those of ordinary skill in the art that various changes and modifications may be made thereto without departing from the scope of the present disclosure as set forth in the following claims.

## Claims

1. A switchable coil comprising:
a first coil including a first outer coil and a first inner coil, the first outer coil including a first crossing end portion and a second crossing end portion, the first inner coil including a third crossing end portion and a fourth crossing end portion, and the third crossing end portion being connected to the first crossing end portion through a crossing segment;
a second coil including a second outer coil and a second inner coil, the second outer coil and the second inner coil forming a crossing-region, and the crossing-region being provided inside the first inner coil viewed in a first direction; and
a switch connected to a region that is in the second inner coil and faces the crossing-region.

2. A switchable coil of claim 1, comprising:
the first coilwherein the first inner coil and the first outer coil form an other crossing-region,
wherein the other crossing-region of the first coil has the second crossing end portion connected to the fourth crossing end portion through a crossing segment.

3. The switchable coil of any preceding claim, wherein a number of windings of the first coil and a number of windings of the second coil is two.

4. The switchable coil of any preceding claim, wherein
the first outer coil includes a first outer end portion and a second outer end portion each extending in a second direction perpendicular to the first direction; and
the second outer coil includes a third outer end portion and a fourth outer end portion, the third outer end portion being overlapped with the first outer end portion, and the fourth outer end portion being overlapped with the second outer end portion.

5. The switchable coil of any preceding claim, wherein the second outer coil includes:
a first inner end portion and a second inner end portion each extending in a second direction perpendicular to the first direction, the switch being connected to the first inner end portion and the second inner end portion.

6. The switchable coil of claim 5, wherein the switch is configured to:
connect the first inner end portion to the second inner end portion based on the switch being turned on in response to a control signal.

7. The switchable coil of claim 6, wherein the switch is configured to:
disconnect the first inner end portion from the second inner end portion based on the switch being turned off in response to the control signal.

8. The switchable coil of at least claim 2 of the preceding claims, wherein the switch and the other crossing-region are outside the crossing-region of the second coil viewed in the first direction.

9. The switchable coil of at least claim 2 of the preceding claims, wherein the crossing-region of the second coil is spaced apart from the other crossing-region of the first coil by a distance in a second direction perpendicular to the first direction.

10. A switchable coil of any preceding claim, comprising an other switch, the other switch connected to the second crossing end portion and the fourth crossing end portion.

11. The switchable coil of any preceding claim, wherein the first outer coil is overlapped with the second outer coil in a first region viewed in the first direction,
preferably wherein the first outer coil is overlapped with the second outer coil in a second region viewed in the first direction.

12. The switchable coil of any preceding claim, wherein the first outer coil includes a different metal from the second outer coil in the first region.

13. The switchable coil of any preceding claim, wherein
the first inner coil is inside the first outer coil viewed in the first direction; and
the second inner coil is inside the second outer coil viewed in the first direction.

14. A transmit circuit comprising:
a mixer configured to perform up-conversion of a transmit signal based on a local oscillator (LO) signal; and
a matching network connected to an output of the mixer, the matching network including at least one switchable coil of any preceding claim.

15. The transmit circuit of claim 14, wherein:
the matching network is configured to have an inductance that varies based on the switch connected to the region in the second inner coil being turned on or off; and/or
wherein the switchable coil is according to at least claim 10 and the matching network is configured to have an inductance that varies based on the other switch being turned on or off.
